# DEMANDE DE BREVET EUROPEEN

(11) **EP 1 162 660 A1**
(43) Date de publication de la demande: **12.12.2001**
(21) Numéro de dépôt: 01401320.5
(22) Date de dépôt: 21.05.2001
(51) Int. Cl.: H01L 23/473, H05K 7/20

(54) **Montage électronique à haute densité d'interconnexions**

(30) Priorité: 08.06.2000 FR 0007352
(71) Demandeur: ALCATEL, 75008 Paris (FR)
(72) Inventeur: Vendier, Olivier, 31120 Lacroix-Falgarde (FR); Huan, Marc, 31480 Cox (FR); Paineau, Sylvain, 92140 Clamart (FR)
(74) Mandataire: Smith, Bradford Lee

(57) **Abrégé**

Montage électronique comportant un module électronique (1) muni d'un moyen d'interconnexion optique et d'un moyen d'évacuation thermique (3, 12), le moyen d'évacuation thermique comportant une semelle (7) dédiée à l'évacuation de chaleur sur laquelle le module est monté. Le moyen d'interconnexion est indépendant de la semelle, et comporte préférentiellement un circuit imprimé (35) et une fibre optique (34) incluse dans ce circuit. La fibre optique comporte une extrémité (36) précisément mise en vis-à-vis avec un contact optique (32) du module par un montage de type BGA du circuit imprimé sur ce module. Un montage de type BGA consiste à déposer précisément d'une part des billes (37) sur le module et d'autre des plages (38) sur le circuit, et ensuite à placer les uns en face des autres pour que les billes s'autocentrent par capillarité avec ces plages.

## Description

La présente invention a pour objet un montage électronique à haute densité d'interconnexions. Elle trouve plus particulièrement son application dans le domaine des modules électroniques intégrés, c'est-à-dire des modules comportant plusieurs circuits intégrés spécialisés, dits ASICs. Ces circuits intégrés spécialisés réalisent de nombreuses fonctions complexes, et nécessitent un nombre important de ports d'entrés et de sorties sur le module pour être desservis. Le domaine de l'invention est notamment celui des modules intégrés ayant une structure tridimensionnelle, et dans un exemple préféré, ayant une forme cubique.

Dans l'état de la technique, on connaît des modules électroniques intégrés cubiques connectés par l'une de leurs faces sur une carte de circuit imprimé. Le module électronique est monté par soudure de pattes du module sur des contacts de report de la carte. On connaît, pour dissiper la chaleur émise par le fonctionnement d'un tel module, un système d'évacuation comportant un drain thermique, tel que le drain thermique est enterré dans la carte. Le module comporte une face posée sur, ou en vis-à-vis avec, une zone de la carte de circuit imprimé. Cette face est la seule interface entre le module et la carte. Donc, les fonctions d'interconnexion et d'évacuation de la chaleur sont réalisées par cette interface.

Le montage de l'état de la technique pose un problème car il empêche d'une part le module de proposer une forte densité d'interconnexions. D'autre part, le système d'évacuation de chaleur prévu est insuffisant car il est réalisé dans la carte de circuit imprimé, alors que d'une part les quantités de chaleur à évacuer sont importantes et que d'autre part le système d'évacuation ne peut pas avoir une dimension trop importante, étant données les conditions de miniaturisation imposées à ces modules intégrés et à ces cartes de circuit imprimé. De plus, la carte ne peut pas recevoir un système d'évacuation miniature, plus performant, car elle est constituée par un substrat réalisé dans un matériau ayant de mauvaises caractéristiques de conduction de la chaleur.

L'invention a pour objet de remédier au problème cité en proposant un montage électronique muni d'un dispositif de refroidissement et proposant de plus un moyen d'interconnexion du module électronique, le moyen d'interconnexion étant distinct du dispositif de refroidissement. L'intérêt de l'invention est d'utiliser la structure tridimensionnelle du module électronique pour séparer les fonctions d'interconnexions des fonctions d'évacuation thermique, et ainsi optimiser chacune de ces fonctions indépendamment l'une de l'autre.

Le dispositif de refroidissement selon l'invention consiste en une semelle isolante reliée à une face du module intégré, cette face étant distincte d'une deuxième face de ce module, la deuxième face étant présentée de telle sorte qu'elle puisse être connectée avec une carte de circuit imprimé. La semelle est sélectionnée pour présenter de bonnes capacités d'échanges thermiques. Et comme elle ne présente aucune fonction d'interconnexions avec ce module, elle peut sans interférences évacuer la grande quantité de chaleur émise par le module.

De plus la deuxième face du module peut être totalement utilisée pour proposer des fonctions d'interconnexions, sans qu'aucun espace n'ait à être réservé pour l'évacuation de chaleur. Par conséquent, l'invention permet de proposer un module présentant une plus haute densité d'interconnexions.

L'invention a pour objet un montage électronique comportant au moins un premier module électronique intégré, le premier module comportant au moins un moyen d'interconnexion pour être éventuellement relié à une carte de circuit imprimé ou à un deuxième module électronique, caractérisé en ce qu'il comporte une semelle et des moyens d'évacuation thermique pour évacuer une chaleur de ce module vers la semelle, et en ce que la semelle est indépendante des moyens d'interconnexion du premier module.

Dans l'état de la technique, on connaît des modules munis de moyens d'interconnexion optique. En effet, les moyens interconnexion optique présentent l'avantage d'être insensibles aux champs électromagnétiques créés dans des environnements tels que ceux entourant les modules selon l'invention. De plus les interconnexions optiques présentent l'avantage de permettre une plus grande densité d'interconnexions qu'avec des interconnexions électroniques.

Dans l'état de la technique un moyen d'interconnexion optique comporte une fibre optique et un ensemble connecteur optique. L'ensemble connecteur comporte un premier connecteur optique monté par exemple sur le module, et un deuxième connecteur optique monté à une extrémité de la fibre optique pour connecter la fibre optique avec le module. Une grande précision d'assemblage du premier connecteur avec le deuxième connecteur est nécessaire. En effet, l'extrémité de la fibre optique doit être très précisément mise en vis-à-vis avec le premier connecteur optique, pour garantir la bonne conduction du signal optique au niveau de l'ensemble connecteur. A cet effet, l'ensemble connecteur comporte au moins un moyen d'alignement de la fibre avec le premier connecteur optique.

Un moyen d'alignement consiste généralement en des moyens de report spécifiques. En général, le moyen d'alignement comporte en plus des lentilles convergentes pour focaliser un faisceau optique véhiculé par l'intermédiaire d'une telle fibre.

Ces contacts et interconnexions optiques présentent un inconvénient majeur. Ils sont complexes et encombrants, et ne permettent pas de concevoir des modules présentant des interconnexions à haute densité et à haut débit. En effet, les premiers moyens de report spécifiques sont encombrants, et empêchent une haute densité d'interconnexions optiques sur ces modules miniatures. Et d'autre part, le placement correct de lentilles convergentes est difficile à réaliser. Enfin ces moyens d'alignement extrêmement précis coûtent chers, et rendent chers l'utilisation des interconnexions optiques sur des modules électroniques intégrés.

L'invention a également pour objet de remédier aux problèmes cités en proposant un module comportant des moyens d'interconnexion optique permettant d'éviter la présence de moyens de report spécifiques pour garantir la précision d'alignement nécessaire à de telles interconnexions optiques. En effet, le moyen d'interconnexion optique selon l'invention ne nécessite plus la présence d'un ensemble connecteur. En effet, l'invention prévoit qu'une fibre optique, par exemple incluse dans un circuit imprimé, soit mise en vis-à-vis avec un contact optique du module par un montage simple et de précision du circuit imprimé sur une face du module présentant le contact optique. Le montage de précision mis en oeuvre est peu encombrant, car les points de contacts entre le circuit imprimé et la face sont limités à des micro-points très précisément disposés respectivement sur la face et sur le circuit imprimé. Et ensuite, ces micro-points sont reliés ensemble par capillarité, lors d'une étape de fusion de ces micro-points alors qu'ils sont placés à une distance très faible les uns des autres.

Ce mode de mise en vis-à-vis permet donc d'augmenter la densité de connecteurs optiques présentés sur un tel module électronique, du fait que la place nécessaire pour les moyens de report spécifiques des connecteurs optiques est désormais disponible pour présenter d'autres contacts optiques.

Dans un exemple préféré, l'invention a pour objet un montage électronique comportant au moins un premier module électronique intégré, une carte de circuit imprimé, et un moyen d'interconnexion optique pour relier le module électronique intégré à la carte de circuit imprimé, caractérisé en ce que le moyen d'interconnexion optique comporte un premier contact optique sur le premier module électronique intégré, et un deuxième contact optique sur la carte de circuit imprimé, et en ce que le premier contact optique est précisément monté en vis-à-vis du deuxième contact optique par l'intermédiaire de billes soudées sur le module, les billes s'autocentrant avec des plages métalliques de la carte de circuit imprimé lors d'un assemblage.

L'invention sera mieux comprise à la lecture de la description qui suit et à l'examen des figures, non à l'échelle, qui l'accompagnent. Celles-ci ne sont présentées qu'à titre indicatif et nullement limitatif de l'invention. Les figures montrent :
- Figure 1 : une vue schématique d'un montage électronique muni d'un moyen d'évacuation thermique selon l'invention ;
- Figure 2 : une vue d'un montage électronique comportant deux modules électroniques munis de moyens d'évacuation thermique selon l'invention et connectés entre eux selon un premier mode de réalisation ;
- Figures 3a : une vue de deux modules électroniques munis de moyens d'évacuation thermique selon l'invention et connectés entre eux selon un deuxième mode de réalisation ;
- Figures 3b : une vue de deux modules électroniques munis de moyens d'évacuation thermique selon l'invention et connectés entre eux selon un troisième mode de réalisation ;
- Figure 4 : une vue de deux modules électroniques munis de moyens d'évacuation thermique selon l'invention et connectés entre eux selon un quatrième mode de réalisation ;
- Figure 5a : une vue d'un module électronique connecté avec une carte de circuit imprimé selon un cinquième mode de réalisation selon l'invention ;
- Figure 5b : une vue d'un module électronique connecté avec une carte de circuit imprimé selon un sixième mode de réalisation selon l'invention ;
- Figure 5c : une vue d'un module électronique connecté avec une carte de circuit imprimé selon un septième mode de réalisation selon l'invention.

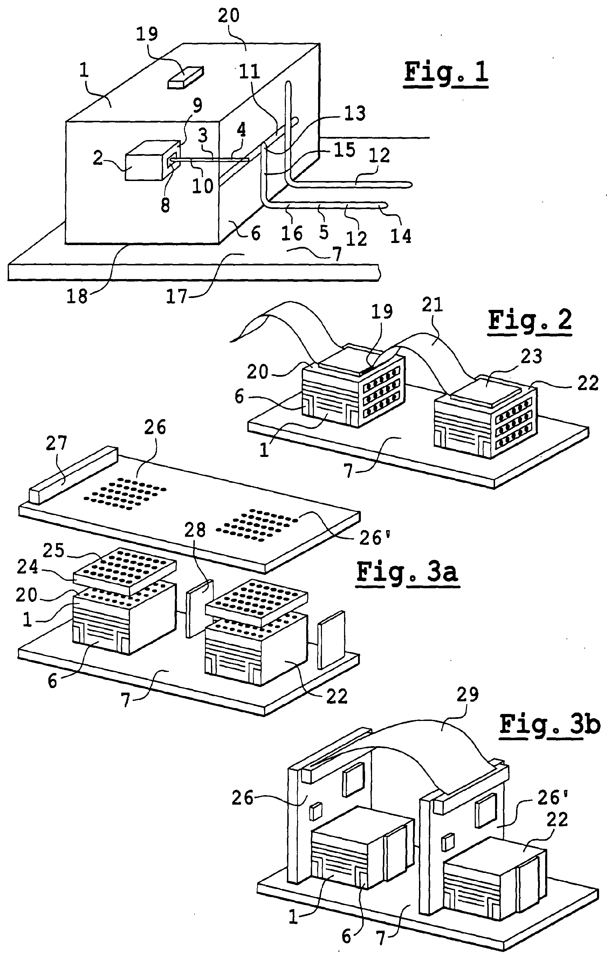

La figure 1 montre un module électronique 1. Le module électronique 1 est préférentiellement un module électronique intégré, de petite taille. Le module électronique 1 a une structure tridimensionnelle, et comporte plusieurs faces. Il propose des ports de connexion d'entrées et ou de sorties sur plusieurs de ses faces.

Le module électronique 1 comporte par exemple un circuit intégré spécialisé 2. Dans un exemple préféré, le module 1 comporte plusieurs circuits intégrés spécialisés tels que 2, dits ASIC, disposés à l'intérieur d'un volume formé par ce module électronique 1. Le module 1 a préférentiellement une forme parallélépipédique, et plus particulièrement une forme cubique. Ainsi, les circuits intégrés spécialisés tels que 2 contenus dans le module 1 peuvent être juxtaposés et ou empilés. Cette structure du module 1 permet de diminuer le poids global de ce module. Le circuit intégré spécialisé 2 est par exemple disposé dans une zone centrale du cube formé par le module 1.

Un circuit intégré spécialisé 2 propose de réaliser de nombreuses fonctions. Donc la puissance dissipée par un tel circuit 2 est importante, et donc un module 1 dégage une grande quantité de chaleur. Par exemple, un module électronique tel que 1 peut comporter cinq circuits ASICs tels que 2, et 250 ports de connexion, le module 1 dissipant alors une puissance de l'ordre de 10 Watts. Dans une variante, un module intégré tel que 1 comportant 600 ports de connexion peut dissiper une puissance pouvant aller jusqu'à 30 Watts.

A cet effet, le module 1 comporte un moyen d'évacuation de la chaleur depuis ce circuit 2 vers l'extérieur. Ce moyen d'évacuation de la chaleur est un drain thermique 3. Notamment dans le cas où le circuit intégré spécialisé 2 est en position centrale, le drain thermique 3 comporte une première portion 4 et une deuxième portion 5.

La première portion 4 assure un transfert de chaleur depuis ce circuit intégré spécialisé 2 vers une face externe 6 du module 1. La première portion 4 prévoit un transfert par conduction.

Par ailleurs, la deuxième portion 5 assure un transfert de la chaleur depuis cette face externe 6 vers une semelle 7 avec laquelle le module 1 est relié. La semelle 7 joue un rôle de puits thermique. Elle est sélectionnée pour présenter de bonnes capacités d'échanges thermiques. La semelle 7 est dédiée à l'évacuation de chaleur et ne propose pas de connexions électroniques avec le module 1, elle peut ainsi évacuer une grande quantité de chaleur. Cette semelle 7 permet d'augmenter le nombre de connexions du module avec d'autres composants.

Etant donné une utilisation préférée d'un tel module 1 dans le domaine de l'aérospatial, une simple convection au niveau de la surface externe 6 ne suffit pas pour assurer un refroidissement suffisant. En effet, la deuxième portion 5 prévoit donc une évacuation de la chaleur par conduction. La face externe 6 est dans l'exemple présenté Figure 1 distincte d'une face de contact du module 1 avec la semelle 7.

Le circuit intégré spécialisé 2 est généralement encapsulé dans une résine ou un matériau plastique. Cette résine d'encapsulation est préférentiellement en silicium. De plus, une matrice principale de constitution du module 1 est également réalisée en résine ou en matériau plastique, et préférentiellement en silicium.

La première portion 4 comporte une puce 8 montée sur un chant 9 du circuit 2. Cette puce 8 est par exemple collée, ou soudée sur le chant 9. Cette puce 8 est constituée dans un matériau ayant un coefficient d'échange thermique quasi identique à celui de la résine d'encapsulation du circuit 2. Par exemple la puce 8 est réalisée dans un matériau composite en aluminium et/ou silicium. Ainsi, on garantit un transfert de chaleur homogène entre le circuit 2 et la puce 8. Et d'autre part, quelles que soient les températures auxquelles sont portés ces éléments, les coefficients de dilatation de la puce 8 et du circuit 2 étant sensiblement identiques, la structure du module 1 reste stable.

La première portion 4 comporte en outre un canal 10 reliant la puce 8 à une zone 11 de la face externe 6. Ce canal 10 est conducteur. Il est préférentiellement réalisé dans un matériau composite à matrices métalliques. Ce matériau est spécifiquement conçu pour permettre de conduire la chaleur depuis le circuit 2 vers la zone 11, sans que pour autant la chaleur véhiculée par ce canal conducteur 10 ne fasse fondre la matrice principale de constitution du module 1. En effet, de même que pour la puce 8, le canal conducteur 10 est réalisé dans un matériau dont le coefficient d'échange thermique est similaire à celui de son environnement dans le module 1.

Etant donné que le module 1, ainsi que la première portion 4 sont réalisés dans des matériaux similaires, ils ont une mauvaise capacité à évacuer la chaleur. La deuxième portion 5 propose un système plus performant que la première portion 4 pour évacuer la chaleur produite par le module 1. A cet effet, la deuxième portion 5 comporte un caloduc 12. Le caloduc 12 comporte une première extrémité 13 et une deuxième extrémité 14. La première extrémité 13 est reliée à la zone 11 de la face externe 6. La deuxième extrémité 14 est montée sur la semelle 7.

Le caloduc 12 est préférentiellement réalisé dans un matériau proposant une bonne conduction de la chaleur. Le caloduc 12 comporte un premier segment 15 monté le long de la face externe 6, et un deuxième segment 16 monté sur une face supérieure 17 de la semelle 7. Le premier segment 15 est par exemple collé sur la face externe 16 par l'intermédiaire d'une colle spéciale. Cette colle spéciale permet d'éviter une fonte de la face externe 6 du module 1, lorsque le caloduc 12 véhicule de la chaleur le long de cette face 6. Ainsi, la conduction de chaleur dans le caloduc 12 n'endommage pas la surface externe 6. Le segment 15 permet d'amener le caloduc 12 jusqu'à la face supérieure 17 de la semelle 7. Le module 1 comporte une face 18, telle que cette face 18 est préférentiellement posée sur cette surface 17. Dans l'exemple présenté Figure 1, la face 18 est orthogonale à la face 6.

Le caloduc 12 est un tube fermé comportant un fluide dans une cavité intérieure. Le fluide du caloduc 12 peut être mis en mouvement à l'intérieur de ce tube par un jeu de gradient de températures. Une circulation du fluide à l'intérieur de la cavité intérieure, entre les extrémités 13 et 14, permet notamment d'effectuer des transferts de chaleur. Dans un mode de réalisation préféré de l'invention, le caloduc 12 est un tube cylindrique dont une paroi intérieure est cannelée. Une circulation du fluide à l'intérieur du caloduc 12 est permise du fait du gradient de températures existant entre les extrémités 13 et 14. En effet, au niveau de l'extrémité 13, au contact avec la zone 11, le fluide contenu à l'intérieur du caloduc 12 est majoritairement en phase vapeur. Puis au fur et à mesure qu'on se rapproche de l'extrémité 14, le fluide est principalement sous forme liquide. Il y a un gradient de phase vapeur à l'intérieur de ce caloduc 12. Ainsi, le fluide est vaporisé au niveau de l'extrémité 13, puis est condensé le long des parois du tube pour retourner sous forme liquide au niveau de l'extrémité 14. Les cannelures du tube permettent d'augmenter les surfaces de contact, et donc les phénomènes de vaporisation - condensation du fluide. Il y a donc un mouvement circulaire entre les extrémités 13 et 14. On assure ainsi une réduction de température de plusieurs degrés entre ces deux extrémités.

Par exemple, ce caloduc 12 peut avoir une longueur totale de 20 cm.
Le caloduc 12 est par exemple un micro capillaire, de par exemple deux millimètres de diamètre. Un fluide contenu dans un tel caloduc 12 est choisi en fonction de sa température de vaporisation, et en fonction d'une gamme de températures d'utilisation d'un tel module 1. Ce caloduc 12 renferme de l'eau et ou de l'alcool, pour une utilisation préférée de ce module 1 dans l'aérospatiale.

Dans une variante, le module 1 est muni de plusieurs deuxième portions telles que 5. En effet, il peut par exemple comporter, comme présenté sur la figure 1, un deuxième caloduc tel que 12. Ces caloducs 12 assurent ensemble la conduction de la chaleur. D'autre part, la multiplicité de ces caloducs 12 permet de proposer des caloducs contenant alternativement soit de l'eau, soit de l'alcool. Or les températures de vaporisation et de condensation de ces deux fluides sont distinctes. Ainsi, notamment pour une utilisation dans l'aérospatial, les caloducs à alcool, qui sont liquides à partir de - 55° C permettent l'évacuation de la chaleur produite par des circuits tels que 2 à basse température, alors que les caloducs à eau ne sont fonctionnels qu'à des températures supérieures à 0° C. Cependant, les caloducs à eau étant plus efficaces que les caloducs à alcool, on munit le module 1 d'une minorité de caloducs à alcool pour évacuer la chaleur au démarrage de l'utilisation du module 1, et d'une majorité de caloducs à eau pour effectuer la conduction massive de la chaleur émise par le module 1 en fonctionnement normal.

Le drain thermique 3 évacue ainsi efficacement la chaleur produite par le module électronique 1 dans la semelle 7.

Pour être rendu fonctionnel, le module électronique 1 comporte au moins un moyen d'interconnexion électronique. La semelle 7 est indépendante de ce moyen d'interconnexion.

Figure 1, le moyen d'interconnexion est un connecteur 19 monté sur une face 20 telle que cette face 20 est distincte de la face 18. Dans un premier mode de réalisation, le connecteur 19 est connecté à un circuit imprimé souple 21 pour relier le module 1 à un deuxième connecteur 23 d'un deuxième module électronique 22.

Le deuxième module 22 peut par exemple être constitué de manière identique au module électronique 1, et alors être également monté sur la surface supérieure 17 de la semelle 7. Dans ce cas, le deuxième module électronique 22 comporte également un montage électronique avec évacuation thermique tel que 3.

Dans une variante, le deuxième module 22 peut être monté sur un substrat équivalant à la semelle 7, et qui soit tel que par exemple des faces supérieures des modules 1 et 22 appartiennent alors à un même plan.

Selon un deuxième mode de réalisation, présenté figure 3a, le moyen d'interconnexion est une matrice de contacts 24 comportant des contacts à ressorts 25, la matrice de contacts 24 étant disposée entre une face telle que 20 du module 1, et une carte de circuit imprimé 26. La carte de circuit imprimé 26 peut par exemple, comme présenté figure 3a, être également connectée au deuxième module 22.

Selon un troisième mode de réalisation, présenté Figure 3b, le moyen d'interconnexion est une matrice de contacts comportant des contacts à ressorts comme représenté à la Figure 3a, mais comportant en plus un deuxième moyen de connexion. Ce deuxième moyen de connexion comporte par exemple une carte de circuit imprimé 26' montée sur le module 22, et un circuit imprimé flexible 29 intermédiaire pour relier la carte de circuit imprimé 26 à la deuxième carte de circuit imprimé 26'.

Ces cartes de circuit imprimé 26 et 26' peuvent par ailleurs présenter d'autres connecteurs 27 pour proposer des connexions avec des éléments autres. Le maintien de la carte 26 sur le module 1 est assuré en partie par l'intermédiaire d'un montage de la carte 26 sur un raidisseur 28. Par exemple, la carte 26 est vissée dans ce raidisseur 28.

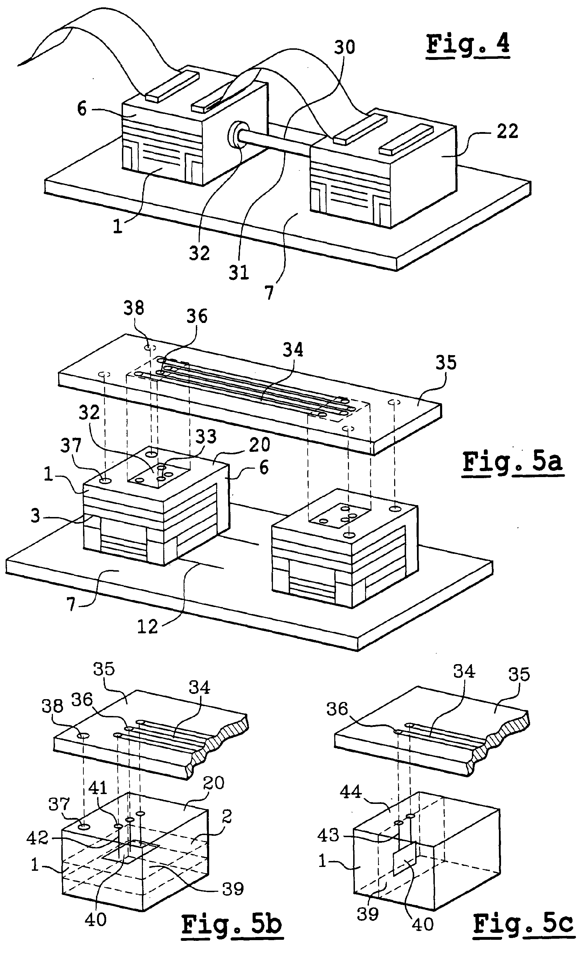

Selon le quatrième mode de réalisation, présenté Figure 4, le moyen d'interconnexion peut être une interconnexion optique 30. Selon ce quatrième mode de réalisation, l'interconnexion optique 30 comporte une fibre optique 31 et un premier connecteur optique 32. Le premier connecteur optique 32 est monté sur le module 1. La fibre optique 31 peut être reliée de plus au module 22 par un deuxième connecteur optique (non représenté). Pour garantir une grande précision quant à la mise en vis-à-vis d'une extrémité d'une fibre optique et d'un connecteur optique, la fibre 31 comporte un connecteur complémentaire du connecteur optique 32. Ce connecteur complémentaire comporte un moyen d'alignement de cette fibre avec le connecteur optique.

Dans un cinquième mode de réalisation, présenté Figure 5a, le moyen d'interconnexion optique comporte au moins un premier connecteur optique 32 présenté sur le module 1, et un deuxième connecteur optique présenté sur un circuit imprimé 35. Par exemple, le connecteur optique 32 est une matrice 32 de contacts optiques 33. Ces contacts optiques 33 peuvent être des diodes, et dans ce cas la matrice 32 est une matrice VCSEL, ou des photodiodes, pour respectivement envoyer ou recevoir un signal optique.

Le deuxième connecteur optique est par exemple une extrémité 36 d'une fibre optique 34 incluse dans le circuit imprimé 35. L'extrémité 36 de la fibre optique 34 est mise en vis-à-vis d'un contact optique 33 de la matrice 32. L'extrémité 36 de la fibre 34 est par exemple courbée à 90° pour qu'une section de cette fibre 34, perpendiculairement à un axe de transmission du signal optique, soit parallèle à un plan formé par le circuit imprimé 35, et notamment soit parallèle à une surface de réception ou d'émission d'un contact optique 33.

Le connecteur optique 32 est préférentiellement disposé sur une face du module 1 ne comportant pas de drains thermiques tels que 3.

La précision du montage et de la mise en regard de l'extrémité 36 de la fibre optique 34 et du contact optique 33 est garantie par un montage de type BGA, Ball Grid Array. En effet, des billes métalliques 37 sont soudées sur la face du module 1 présentant le connecteur optique 32. Ces billes 37 sont préférentiellement réalisées en étain plomb. La soudure de ces billes 37 est effectuée par un automate, qui place ces billes 37 à des endroits bien précis sur le module 1, et garantit également une forme bombée pour chacune de ces billes 37.

Par ailleurs, la carte de circuit imprimé 35 comporte des plages d'accueil 38 de ces billes 37. Une plage d'accueil 38 consiste préférentiellement en une plage ronde métallique du circuit imprimé 35. Ces plages métalliques 38 sont réalisées dans une matière dont la température de fusion est inférieure à celle de la bille 37. Ces plages d'accueil 38 sont également réparties de manière très précise sur le circuit imprimé 35 par l'intermédiaire d'un automate.

Lors du montage du module 1 sur la carte de circuit imprimé 35, on dispose grossièrement le module 1 en vis-à-vis du circuit imprimé et on place l'ensemble dans un four. Dans ce four, les billes 37 sont portées à hautes températures et deviennent partiellement liquides.

Puis par capillarité, lors de la fonte des billes 37, on aboutit à un alignement parfait des billes 37 présentées sur le module 1 avec les plages d'accueil 38 du circuit imprimé 35. En effet, le circuit imprimé 35 est placé à une distance très faible de ces billes 37, de telle sorte que le positionnement du module électronique 1 sur la carte de circuit imprimé 35 se fait automatiquement par un léger déplacement de ce module 1 par rapport à la carte 35 pour que les billes 37 soient disposées correctement en vis-à-vis des plages métalliques 38 du circuit imprimé 35 avec lesquels elles fusionnent. Le léger déplacement est notamment obtenu par des forces de capillarité.

Le module 1 est alors monté de manière très précise sur le circuit imprimé 35. De même que la connexion entre les billes 37 et les plages d'accueil 38 du circuit imprimé 35 est précise, on obtient la même précision d'alignement des contacts optiques 33 avec les extrémités 36 des fibres optiques 34.

Ces connexions physiques, obtenues par fusion entre les billes 37 et les plages d'accueil 38, permettent notamment de constituer des entrées et sorties statiques, notamment prévues pour véhiculer des signaux, préférentiellement des signaux non sensibles aux champs électromagnétiques. Par exemple, les billes 37 peuvent être reliées à un circuit intégré spécialisé tel que 2 du module 1, et respectivement les plages 38 peuvent être reliées à des pistes conductrices du circuit imprimé 35. Ces entrées et sorties statiques complètent la possibilité d'interconnexion déjà proposée par le premier moyen d'interconnexion optique, lequel moyen d'interconnexion optique constitue des entrées et sorties dynamiques.

Par un tel système de connexion on obtient un espace entre les contacts optiques 32 et l'extrémité 36 de la fibre 34 de l'ordre de 250 µm. Ainsi l'utilisation de lentilles convergentes, pour faire converger un signal optique véhiculé entre le contact 33 et l'extrémité 36, n'est plus nécessaire. De plus, étant donné la facilité de mise en vis-à-vis des extrémités des fibres optiques incluses dans un circuit imprimé avec des contacts optiques, on peut augmenter la densité de contacts optiques présentés sur le module 1.

Par ailleurs, pour garantir l'alignement précis et permanent des contacts optiques 33 avec les extrémités 36 des fibres optiques 34 incluses dans le circuit imprimé 35, on choisit un circuit imprimé 35 et un module 1 ayant un même coefficient de dilatation. Ainsi quelles que soient les variations de températures appliquées à ces différents éléments, l'alignement de l'interconnexion optique reste conservé.

Dans une variante, on peut prévoir que le deuxième module 22 soit connecté de la même manière que le module 1 avec la carte de circuit imprimé 35, de telle sorte qu'une extrémité de la fibre optique 34 incluse dans ce circuit imprimé 35, soit en vis-à-vis avec des contacts optiques tels que 33 du module 22. Ainsi on obtient une interconnexion optique entre les modules 1 et 22 ne nécessitant pas la présence de connecteurs complémentaires de ces contacts optiques sur le circuit imprimé 35.

Dans un sixième mode de réalisation, présenté Figure 5b, le module 1 comporte plusieurs circuits intégrés spécialisés tels que 2, par exemple ces circuits intégrés spécialisés sont disposés parallèlement entre eux et parallèlement à une carte de circuit imprimé telle que 35, la carte de circuit imprimé étant destinée à être montée sur une face telle que 20 du module 1, de la même manière que selon le cinquième mode de réalisation. Ainsi, dans ce sixième mode de réalisation la carte de circuit imprimé telle que 35 est montée sur le module 1 en utilisant un montage de type BGA. Un circuit intégré spécialisé 39 disposé à l'intérieur du module 1 comporte un composant électronique 40 muni d'une interface optoélectronique. Ce composant électronique 40 n'est pas présenté au niveau de la surface 20. En effet, il est situé à l'intérieur du module 1. Donc pour connecter l'interface optoélectronique de ce composant 40, on met en vis-à-vis les extrémités telles que 36 des fibres telles que 34 du circuit imprimé tel que 35 avec des sections 41 de fibres optiques 42. Les fibres optiques 42 sont reliées avec l'interface optoélectronique du composant 40.

Un septième mode de réalisation, présenté Figure 5c, est une variante du sixième mode de réalisation. Selon ce septième mode de réalisation, le circuit intégré spécialisé tel que 39 est disposé perpendiculairement à une face telle que 20, la face telle que 20 étant destinée à être montée sur une carte de circuit imprimé telle que 35 selon un montage du type BGA. Selon ce mode de réalisation, le composant tel que 40 du circuit tel que 39 est destiné à être connecté avec des extrémités telles que 36 des fibres telles que 34 du circuit tel que 35 par l'intermédiaire de fibres optiques 43. Les fibres optiques 43 sont reliées au composant 40 et noyées dans la résine du circuit intégré spécialisé. Les fibres optiques 43 présentent chacune une section 44 affleurant au niveau de la surface telle que 20. Les sections 44 sont montées en vis-à-vis des extrémités telles que 36.

Dans une variante de ce septième mode de réalisation, les fibres 43 sont remplacées par des guides d'ondes optiques intégrés dans la résine du circuit intégré spécialisé 39.

Dans un mode préféré de réalisation, les extrémités 36, 41 et 44 des fibres optiques respectivement 34, 42 et 43, des cinquième, sixième et septième modes de réalisation, comportent une lentille gravée pour améliorer la qualité de la transmission optique du signal. Cette lentille gravée peut être réfractive ou diffractive.

## Revendications

1. Montage électronique comportant au moins un premier module électronique intégré (1), le premier module comportant au moins un moyen d'interconnexion pour être éventuellement relié à une carte de circuit imprimé (26, 26', 35) ou à un deuxième module électronique (22), **caractérisé en ce qu'**il comporte une semelle (7) et des moyens d'évacuation thermique (3, 4, 5, 12) pour évacuer une chaleur de ce module vers la semelle, et **en ce que** la semelle est indépendante des moyens d'interconnexion du premier module.

2. Montage selon la revendication 1 **caractérisé en ce que** le moyen d'interconnexion comporte une fibre optique (31, 34).

3. Montage selon la revendication 2 **caractérisé en ce que** la fibre optique est incluse dans une carte de circuit imprimé (35), et **en ce qu'**une première extrémité de la fibre est montée en vis-à-vis d'un contact optique (33) du premier module, par l'intermédiaire de billes soudées (37) sur le module et précisément disposées avec des plages métalliques (38) de la carte de circuit imprimé, l'extrémité de la fibre optique comportant préférentiellement une lentille gravée.

4. Montage selon l'une des revendications 1 à 3 **caractérisé en ce que** le moyen d'interconnexion comporte un circuit imprimé flexible (21).

5. Montage selon l'une des revendications 1 à 4 **caractérisé en ce que** le moyen d'interconnexion comporte une portion de carte de circuit imprimé (26) connectée au premier module et une deuxième portion de carte de circuit imprimé (26') connectée au deuxième module, les deux cartes étant reliées entre elles par un deuxième moyen d'interconnexion.

6. Montage selon la revendication 5 **caractérisé en ce que** les deux cartes sont solidaires et le deuxième moyen d'interconnexion est constitué par des pistes reliant les deux portions de carte.

7. Montage selon la revendication 5 **caractérisé en ce que** le deuxième moyen d'interconnexion est un circuit imprimé flexible (29).

8. Montage selon l'une des revendications 1 à 7 **caractérisé en ce que** le moyen d'interconnexion comporte une matrice de contacts (24), la matrice de contacts étant par exemple montée entre le module et une carte de circuit imprimé.

9. Montage selon l'une des revendications 1 à 8 **caractérisé en ce que** les moyens d'évacuation thermique comportent un premier tronçon (4) et un deuxième tronçon (5), le premier tronçon reliant le circuit intégré spécialisé à une première face (6) du module, cette première face étant distincte d'une deuxième face de contact (18) entre le module et la semelle, et le deuxième tronçon reliant cette deuxième face à la semelle.

10. Montage selon la revendication 9 **caractérisé en ce que** le premier tronçon comporte un canal conducteur (10).

11. Montage selon l'une des revendications 9 à 10 **caractérisé en ce que** le deuxième tronçon comporte un caloduc (12) fermé contenant un fluide, préférentiellement de l'eau et/ou de l'alcool.

12. Montage selon la revendication 11 **caractérisé en ce que** le caloduc est un tube cylindrique long dont une paroi intérieure est cannelée.
